(19) Europäisches Patentamt
European Patent Office
Office européen des brevets

(11) Veröffentlichungsnummer: **0 153 682**
**B1**

(12) **EUROPÄISCHE PATENTSCHRIFT**

(45) Veröffentlichungstag der Patentschrift: **02.05.90**

(51) Int. Cl.$^5$: **G 03 F 7/039,** G 03 F 7/004

(21) Anmeldenummer: **85101726.9**

(22) Anmeldetag: **16.02.85**

# (54) Strahlungsempfindliches Gemisch auf Basis von säurespaltbaren Verbindungen.

(30) Priorität: **25.02.84 DE 3406927**

(43) Veröffentlichungstag der Anmeldung:
**04.09.85 Patentblatt 85/36**

(45) Bekanntmachung des Hinweises auf die Patenterteilung:
**02.05.90 Patentblatt 90/18**

(84) Benannte Vertragsstaaten:
**AT BE CH DE FR GB IT LI NL SE**

(56) Entgegenhaltungen:
**EP-A-0 042 562**
**EP-A-0 066 452**
**DE-A-1 797 282**
**FR-A-2 183 748**

**CHEMICAL ABSTRACTS, Band 101, Nr. 22, 26. November 1984, Seite 610, Zusammenfassung Nr. 201546k, Columbus, Ohio, US; & DD-A-206 518**

(73) Patentinhaber: **HOECHST AKTIENGESELLSCHAFT**
**Postfach 80 03 20**
**D-6230 Frankfurt am Main 80 (DE)**

(72) Erfinder: **Schneller, Arnold, Dr. Dipl.-Chem.**
**Asternweg 41**
**D-6500 Mainz 21 (DE)**
Erfinder: **Herwig, Walter, Dr. Dipl.-Chem.**
**Hasenpfad 7**
**D-6232 Bad Soden (DE)**
Erfinder: **Erbes, Kurt**
**Friedrich-Stolz-Strasse 3**
**D-6093 Flörsheim 3 (DE)**



Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

**Beschreibung**

Strahlungsempfindliches Gemisch auf Basis von säurespaltbaren Verbindungen.

Die Erfindung betrifft ein strahlungsempfindliches Gemisch, das als wesentliche Bestandteile

a) ein in Wasser unlösliches, in wäßrig-alkalischen Lösungen lösliches polymeres Bindemittel,

b) eine unter Einwirkung von aktinischer Strahlung eine starke Säure bildende Verbindung und

c) eine Verbindung mit mindestens einer durch Säure spaltbaren C-O-C-Bindung.

enthält und zur Herstellung von Druckplatten und Photoresists geeignet ist.

Positiv arbeitende lichtempfindliche Gemische, d.h. Gemische, deren Kopierschicht an den belichteten Stellen löslich wird, aus den genannten Bestandteilen sind bekannt.

Diese Gemische enthalten als alkalilösliche Bindemittel in der überwiegenden Mehrzahl Phenol-Formaldehyd-Kondensationsprodukte, insbesondere Novolake. Als weitere mögliche alkalilösliche Bindemittel werden Copolymerisate von Maleinsäureanhydrid und Styrol, von Vinylacetat und Crotonsäure, von Methylmethacrylat und Methacrylsäure oder durch Chloressigsäure modifizierte Novolake erwähnt, z.B. in der DE—C—27 18 254. Diese Copolymerisate werden offensichtlich nicht bevorzugt. Praktisch alle bekannten Handelsprodukte enthalten deshalb Novolake. Die Novolake als Bindemittel haben für bestimmte Anwendungszwecke Nachteile.

Bedingt durch die chemische Konstitution und das durch die Synthese vorgegebene niedrige Molekulargewicht der Novolakharze sind diese Schichten relativ spröde, so daß es bei der Verarbeitung oft zu Brüchen der Schicht kommt, z.B. beim Belichten im Kontakt mit einer Maske oder beim Laminieren als Trockenresist auf eine Trägeroberfläche. Diese Eigenschaft wirkt sich besonders stark bei den für Trockenresistmaterialien bevorzugten größeren Schichtdicken aus.

In der EP—A—0 042 562 wird ein entsprechendes lichtempfindliches Gemisch beschreiben, das zur Erhöhung der Flexibilität der Schicht und zur Verbesserung anderer Eigenschaften zusätzlich zu dem alkalilöslichen Bindemittel ein weiteres Polymeres enthält, z.B. ein Polyurethan, einen Polyvinylalkylether, ein Polyalkylacrylat oder ein hydriertes Kolophoniumderivat. Durch den Zusatz dieser Harze, die ein anderes Löslichkeitsverhalten als Novolake haben, werden aber wieder andere Eigenschaften, wie Entwickelbarkeit, Säure- oder Alkaliresistenz der Bildschablonen, beeinträchtigt.

Es sind auch andere positiv arbeitende lichtempfindliche Gemische bekannt, die o-Chinondiazide und Novolake enthalten. Diese Gemische, die in großem Umfang zur Herstellung von Flachdruckplatten verwendet werden, bilden ebenfalls relativ spröde Schichten. Auch diese lichtempfindlichen Systeme hat man mit anderen alkalilöslichen Verbindungen kombiniert, um bestimmte Eigenschaften zu verändern. So wird in der DE—C—23 22 230 eine Kombination von verschiedenen lichtemfindlichen Verbindungen, z.B. von o-Naphthochinondiaziden, mit Polyvinylphenolen beschreiben. Die damit erhaltenen Druckplatten zeichnen sich durch erhöhte Druckauflage und Ätzresistenz aus. In der Beschreibung wird erwähnt, daß man der Schicht — ähnlich wie bei Novolak enthaltenden Schichten — Weichmacher zusetzen kann. Auch diese Materialien haben bisher keinen Eingang in die Praxis gefunden.

Die Gemische mit o-Chinondiaziden als lichtempfindliche Verbindungen haben gegenüber den Gemischen mit den eingangs genannten säurespaltbaren Verbindungen den Nachteil einer deutlich geringeren Lichtempfindlichkeit. Das wirkt sich besonders bei Anwendungen aus, bei denen höhere Schichtdicken erforderlich sind, z.B. beim Trockenresistverfahren.

Aufgabe der Erfindung war es, strahlungs- bzw. lichtempfindliche Gemische der eingangs erwähnten Gattung bereitzustellen, die sich mit wäßrig-alkalischen Lösungen entwickeln lassen und die lichtempfindliche Schichten mit einer gegenüber den bekannten Gemischen erhöhten Flexibilität bilden.

Gegenstand der Erfindung ist ein strahlungsempfindliches Gemisch, das

a) ein in Wasser unlösliches, in wäßrig-alkalischen Lösungen lösliches polymeres Bindemittel,

b) eine unter Einwirkung von aktinischer Strahlung eine starke Säure bildende Verbindung und

c) eine Verbindung mit mindestens einer durch Säure spaltbaren C—O—C-Bindung enthält, deren Löslichkeit in einem flüssigen Entwickler durch Einwirkung von Säure erhöht wird.

Das erfindungsgemäße Gemisch ist dadurch gekennzeichnet, daß das Bindemittel ein Polymerisat ist, das Alkenylphenoleinheiten enthält.

Bevorzugt werden Polymerisate mit Einheiten der allgemeinen Formel I

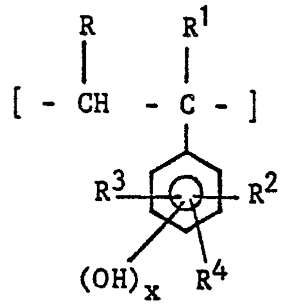

(I)

worin

R ein Wasserstoffatom, eine Cyanid-, Alkyl- oder Phenylgruppe,

$R^1$ ein Wasserstoff- oder Halogenatom, eine Cyanid- oder Alkylgruppe,

$R^2$, $R^3$ und $R^4$ Wasserstoff-, Halogenatome, Alkyl- oder Alkoxygruppen und

x eine Zahl von 1 bis 3

bedeuten.

R ist bevorzugt ein Wasserstoffatom oder eine Alkylgruppe mit 1—4 Kohlenstoffatomen, insbesondere eine Methylgruppe. $R^1$ ist ebenfalls bevorzugt ein Wasserstoffatom. Wenn es eine Alkylgruppe bedeutet, kann diese im allgemeinen 1—4, bevorzugt 1—2 Kohlenstoffatome haben; sie ist insbesondere eine Methylgruppe.

Von den Substituenten $R^2$, $R^3$ und $R^4$ ist bevorzugt mindestens einer ein Wasserstoffatom, besonders bevorzugt sind mindestens zwei davon Wasserstoffatome. Wenn diese Symbole Alkyl- oder Alkoxygruppen bedeuten, haben diese bevorzugt 1—6, insbesondere 1—3 Kohlenstoffatome. X ist bevorzugt kleiner als 3, insbesondere 1.

Für X = 1 kann die Hydroxylgruppe in jeder beliebigen o-, m- oder p-Stellung angeordnet sein, für Disubstitution (x = 2) und Trisubstitution (x = 3) kommen ebenfalls alle möglichen Kombinationen in Betracht, bevorzugt die m- und p-Positionen.

Die Position der Reste $R^2$, $R^3$ und $R^4$ unterliegt keiner Beschränkung, sie richtet sich nach der Stellung der Hydroxygruppen.

Allgemein sind hier unter Alkylgruppen verzweigte und unverzweigte, gesättigte und ungesättigte Gruppen mit cyclischen oder offenen Ketten zu verstehen, die durch Halogenatome oder Hydroxygruppen substituiert sein oder Ether- oder Ketogruppen enthalten können. Bevorzugt werden unverzweigte Kohlenwasserstoffreste mit 1 bis 3 Kohlenstoffatomen.

Die Polymeren mit Einheiten der Formel I können Homopolymerisate, welche ausschließlich Struktureinheiten der Formel I enthalten, oder Mischpolymerisate aus Monomeren entsprechend der Formel I und einem oder mehreren anderen Vinylmonomeren sein.

Die Auswahl von geeigneten Homopolymeren oder Copolymeren richtet sich im Einzelfall nach der Anwendung und nach Art der übrigen Komponenten in der Kopierschicht. So läßt sich z.B. die Hydrophilie des Bindemittels durch den Gehalt an hydrophoben Comonomeren gezielt steuern und somit auf die übrigen Komponenten einstellen. Weiterhin läßt sich die Erwichungstemperatur durch Wahl der Substituenten am Aromaten und vor allem durch Wahl der Comonomeren beeinflussen.

Das Molekulargewicht der Homo- bzw. Copolymeren kann in weiten Grenzen variiert werden; bevorzugt werden Polymerisate mit $\overline{M}_n$ = 1000—200.000, besonders solche mit $\overline{M}_n$ = 5000—100.000. Die Hydroxylzahl liegt im allgemeinen im Bereich von 100 bis etwa 450, vorzugsweise zwischen 200 und 350.

Die Polymeren lassen sich herstellen durch Polymerisation in der Masse, durch Emulsions- oder Lösungspolymerisation der entsprechenden Monomeren in Gegenwart von kationischen Initiatoren, z.B. Bortrifluoridetherat. Ebenso lassen sich diese Monomeren radikalisch durch Hitze, Strahlung oder Initiatoren, z.B. Azo-bis-isobuttersaürenitril, polymerisieren. Solche Prozesse sind beschrieben in J. Polym. Sci. A1,7, 2175—2184 und 2405—2410 (1969).

Die entsprechenden Alkenylphenole lassen sich z.B. durch Decarboxylierung von Hydroxyzimtsäuren herstellen, die wiederum aus substituierten oder unsubstituierten Hydroxybenzaldehyden und Malonsäure erhalten werden. Weiterhin liefert die alkalische Spaltung von gegebenenfalls substituiertem Bisphenol A Alkenylphenole mit substituiertem α-C-Atom. Eine weitere Möglichkeit bietet die Dehydratisierung von entsprechend substituierten Hydroxyalkylphenolen. Methoden zur Herstellung werden beschreiben im Journal of Organic Chemistry, Vol. 23, S. 544—549 (1958) und im Journal of Polymer Science, Polymer Chemistry Edition, Vol. 12, Seite 2017—2020 (1974).

Als Comonomere in Verbindung mit den Alkenyl- bzw. Vinylphenolen werden Verbindungen der allgemeinen Formel

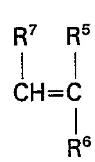

bevorzugt, worin

$R^5$ ein Wasserstoff- oder Halogenatom oder eine Alkylgruppe,

$R^6$ eine Alkyl-, Alkoxy-, Alkyloxycarbonyl-, Acyl-, Acyloxy-, Aryl-, Formyl-, Cyanid-, Carboxyl-, Hydroxy- oder Aminocarbonylgruppe und

$R^7$ ein Wasserstoffatom oder eine Carboxylgruppe ist, die mit $R^6$, wenn dieses eine Carboxylgruppe ist, zu einem Säureanhydrid verbunden sein kann.

Wenn $R^5$ oder $R^6$ Alkylgruppen sind, haben diese im allgemeinen 1—4 Kohlenstoffatome; als Vertreter für $R^6$ kommen in Betracht: Alkoxygruppen mit 1—8 C-Atomen, Alkyloxycarbonylgruppen mit 2—13 C-Atomen, Acylgruppen mit 2—9 C-Atomen und Acyloxygruppen mit 2—5 C-Atomen. Die Aminocarbonylgruppen können unsubstituiert oder durch eine oder zwei Alkylgruppen mit 1—8 C-Atomen

substituiert sein. Die Alkylgruppen haben die oben angegebene Bedeutung.

Beispiele für solche Verbindungen sind Stryrol, α-Chlorstyrol, α-Methylstyrol, 2-, 3- oder 4-Chlormethyl-styrol, 4-Brom-styrol, Methylvinylether, Ethylvinylether, Propylvinylether, Butylvinylether, Acrylnitril, Acrolein, Butadien, Acrylsäure, Methacrylsäure, die Methyl-, Ethyl-, Propyl-, Butyl-, Pentyl-, Hexyl-, Hydroxyethyl- und 2-Ethylhexylester dieser Säuren, Methacrylamid, Acrylamid, Vinylacetat, Vinylisobutylketon und Maleinsäureanhydrid.

Beispiele für Copolymere sind
(p-, m-, o-) Vinylphenol/Styrol-Copolymere,
(p-, m-, o-) Vinylphenol/Alkylmethacrylat-Copolymere,
(p-, m-, o-) Vinylphenol/Alkylacrylat-Copolymere,
(p-, m-, o-) Isopropenylphenol/Styrol-Copolymere,
(p-, m-, o-) Isopropenylphenol/Alkylmethacrylat-Copolymere,
(p-, m-, o-) Vinylphenol/Maleinsäureanhydrid-Copolymere, Isoeugenol/Maleinsäureanhydrid-Copolymere.

Der Gehalt an Alkenylphenoleinheiten im Copolymeren richtet sich nach den übrigen Komponenten des Gemisches und nach der Anwendung. Im allgemeinen werden im erfindungsgemäßen Gemisch Polymere mit einem Gehalt von 20 bis 100 mol-%, vorzugsweise 40 bis 90 mol-% an Alkenylphenoleinheiten eingesetzt.

Zur Herstellung der erfindungsgemäßen Gemische wird das beschriebene Bindemittel kombiniert mit Verbindungen, die mindestens eine durch Säure spaltbare C—O—C-Bindung enthalten und mit Substanzen, die bei Belichtung oder durch Einwirkung von energiereicher Strahlung Säuren bilden.

Als durch Säure spaltbare Verbindungen sind in erster Linie zu nennen:

a) solche mit mindestens einer Orthocarbonsäureester- und bzw. oder Carbonsäureamidacetalgruppierung, wobei die Verbindungen auch polymeren Charakter haben und die genannten Gruppierungen als verknüpfende Elemente in der Hauptkette oder als seitenständige Substituenten auftreten können,

b) Oligomer- oder Polymerverbindungen mit wiederkehrenden Acetal- und/oder Ketalgruppierungen in der Hauptkette und

c) Verbindungen mit mindestens einer Enolether- oder N-Acyliminocarbonatgruppierung.

Durch Säure spaltbare Verbindungen des Typs a) als Komponenten strahlungsempfindlicher Gemische sind in der EP—A—0 022 571 ausführlich beschreiben; Gemische, die Verbindungen des Typs b) enthalten, sind in der DE—C—23 06 248 und der DE—C—27 18 254 beschreiben; Verbindungen des Typs c) werden in den EP—A—0 006 626 und 0 006 627 beschreiben.

Die Art und die Menge des Bindemittels und der spaltbaren Verbindung kann je nach Anwendungsart verschieden sein; bevorzugt werden Anteile des Bindemittls zwischen 30 und 90 Gew.-%, besonders bevorzugt 55 bis 85 Gew.-%. Der Anteil der spaltbaren Verbindung kann variiert werden zwischen 5 und 70 Gew.-%, bevorzugt werden 5 bis 40 Gew.-%.

Zusätzlich können noch zahlreiche andere Oligomere und Polymere mitverwendet werden, z.B. Phenolharze vom Novolaktyp oder Vinylpolymerisate wie Polyvinylacetale, Polymethacrylate, Polyacrylate, Polyvinylether und Polyvinylpyrrolidone, die selbst durch Comonomere modifiziert sein können.

Der günstigste Anteil an diesen Zusätzen richtet sich nach den anwendungstechnischen Erfordernissen und dem Einfluß auf die Entwicklungsbedingungen und beträgt im allgemeinen nicht mehr als 40% vom Alkenylphenolpolymerisat. In geringen Mengen kann die lichtempfindliche Schicht für spezielle Erfordernisse wie Flexibilität, Haftung, Glanz etc. außerdem noch Substanzen wie Polyglykole, Celluloseether, z.B. Ethylcellulose, Netzmittel, Verlaufmittel, Farbstoffe und feinteilige Pigmente enthalten.

Als strahlungsempfindliche Komponenten, die beim Bestrahlen vorzugsweise starke Säuren bilden bzw. abspalten, sind eine große Anzahl von kebannten Verbindungen und Mischungen, wie Diazonium-, Phosphonium-, Sulfonium- und Jodonium-Salze, Halogen-Verbindungen, o-Chinondiazidsulfochloride und Organometall-Organohalogen-Kombinationen geeignet.

Die genannten Diazonium-, Phosphonium-, Sulfonium- und Jodonium-Verbindungen werden in der Regel eingesetzt in Form ihrer in organischen Lösungsmitteln löslichen Salze, meist als Abscheidungsprodukt mit komplexen Säuren wie Borfluorwasserstoffsäure, Hexafluorphosphor-, Hexafluorantimon- und -arsensäure.

Grundsätzlich sind als halogenhaltige strahlungsempfindliche und Halogenwasserstoffsäure bildende Verbindungen alle auch als photochemische Radikalstarter bekannten organischen Halogenverbindungen, beispielsweise solche mit mehr als einem Halogenatom an einem Kohlenstoffatom oder an einem aromatischen Ring, brauchbar. Beispiele sind in den US—A—3 515 552, 3 536 489 und 3 779 778, der DE—C—26 10 842 und den DE—A—22 43 621, 27 18 259 und 33 37 024 beschreiben. Von diesen Verbindungen werden die s-Triazinderivate mit 2 Halogenmethylgruppen, insbesondere Trichlormethylgruppen, und einem aromatischen bzw. ungesättigten Substituenten im Triazinkern, wie sie in den DE—A—27 18 259 und 33 37 024 beschreiben sind, bevorzugt. Die Wirkung dieser halogenhaltigen Verbindungen kann auch durch bekannte Sensibilisatoren spektral beeinflußt und gesteigert werden.

Beispiele für geeignete Starter sind: 4 - (Di - n - propylamino) - benzoldiazoniumtetrafluoroborat, 4 - p - Tolylmercapto - 2,5 - diethoxy - benzoldiazoniumhexafluorophosphat und -tetrafluoroborat,

Diphenylamin - 4 - diazoniumsulfat, 4 - Methyl - 6 - trichlormethyl - 2 - pyron, 4 - (3,4,5 - Trimethoxystyryl) - 6 - trichlormethyl - 2 - pyron, 4 - (4 - Methoxy - styryl) - 6 - (3,3,3 - trichlor - propenyl) - 2 - pyron, 2 - Trichlormethylbenzimidazol, 2 - Tribrommethyl - chinolin, 2,4 - Dimethyl - 1 - tribromacetyl - benzol, 3 - Nitro - 1 - tribromacetyl - benzol, 4 - Dibromacetyl - benzoesäure, 1,4 - Bis - dibrommethyl - benzol, Tris - dibrommethyl - s - triazin, 2 - (6 - Methoxy - naphth - 2 - yl)-, 2 - (Naphth - 1 - yl)-, 2 - (Naphth - 2 - yl)-, 2 - (4 - Ethoxyethyl - naphth - 1 - yl)-, 2 - (Benzopyran - 3 - yl)-, 2 - (4 - Methoxyanthrac - 1 - yl)-, 2 - (4 - Styryl - phenyl)-, 2 - (Phenanthr - 9 - yl) - 4,6 - bis - trichlormethyl - s - triazin und die in den Beispielen angeführten Verbindungen.

Die Menge des Starters kann je nach seiner chemischen Natur und der Zusammensetzung des Gemischs ebenfalls sehr verschieden sein. Günstige Ergebnisse werden erhalten mit etwa 0,1 bis 10 Gew.-%, bezogen auf den Gesamtfeststoff, bevorzugt sind 0,2 bis 5%. Besonders für Kopierschichten von Dicken über 10 µm empfiehlt es sich, relativ wenig Säurespender zu verwenden.

Schließlich können dem lichtempfindlichen Gemisch noch lösliche oder auch feinteilige dispergierbare Farbstoffe sowie je nach Anwendungszweck auch UV-Absorber zugesetzt werden. Als Farbstoffe haben sich die Triphenylmethanfarbstoffe, insbesondere in der Form ihrer Carbinolbasen, besonders bewährt. Die günstigsten Mengenverhältnisse der Komponenten lassen sich im Einzelfall durch Vorversuche leicht ermitteln.

Als Schichtträger für die lichtempfindlichen Gemische eignen sich alle üblicherweise in der Technik in Kopierprozessen eingesetzten Materialien. Als Beispiele seien Kunststoffolien, Isolierplatten mit Kupferauflage, mechanische oder elektrochemisch aufgerauhtes und ggf. anodisiertes Aluminium, Holz, Keramik, Glas und Silicium, dessen Oberfläche chemisch z.B. in Siliciumnitrid oder Siliciumdioxid umgewandelt sein kann, genannt.

Bevorzugte Träger für dicke Schichten über 10 µm sind Kunststoffolien, die dann als temporäre Träger für Transferschichten dienen. Dafür und für Farbfolien werden Polyesterfolien, z.B. aus Polyethylenterephthalat, bevorzugt. Polyolefinfolien wie Polypropylen sind jedoch ebenfalls geeignet. Als Schichtträger für Schichtdicken unter ca. 10 µm werden meist Metalle verwendet. Für Offsetdruckplatten können eingesetzt werden: mechanisch oder chemisch aufgerauhtes und gegebenenfalls anodisiertes Aluminium, das zudem noch chemisch, z.B. mit Polyvinylphosphonsäure, Silikaten oder Phosphaten, vorbehandelt sein kann.

Schließlich kann die Beschichtung direkt oder durch Schichtübertragung, vom temporären Schichtträger erfolgen auf Leiterplatten-Materialien, die aus Isolierplatten mit ein- oder beidseitiger Kupferauflage bestehen, auf Glas oder Keramik-Materialien, die gegebenenfalls haftvermittelnd vorbehandelt sind, und auf Silicium-Scheiben. Außerdem können Holz, Textilien und Oberflächen vieler Werkstoffe beschichtet werden, die vorteilhaft durch Projektion bebildert werden und resistent gegen die Einwirkung alkalischer Entwickler sind.

Für die Trocknung nach der Beschichtung können die üblichen Geräte und Bedingungen übernommen werden, Temperaturen um 100°C und kurzfristig bis 120°C werden ohne Einbuße an Strahlungsempfindlichkeit vertragen.

Zum Belichten können die üblichen Lichtquellen wie Röhrenlampen, Xenonimpulslampen, metallhalogeniddotierte Quecksilberdampf-Hochdrucklampen und Kohlebogenlampen verwendet werden.

Unter Bestrahlung ist in dieser Beschreibung die Einwirkung aktinischer elektromagnetischer Strahlung im Wellenlängenbereich unterhalb etwa 500 nm zu verstehen. Alle in diesem Wellenlängenbereich emittierenden Strahlungsquellen sind prinzipiell geeignet.

Mit besonderem Vorteil werden Laserbestrahlungsgeräte, insbesondere automatische Verarbeitungsanlagen verwendet, die als Strahlungsquelle einen Argon-Ionen-Laser enthalten.

Die Bestrahlung kann auch mit Elektronenstrahlen erfolgen. In diesem Falle können auch im üblichen Sinne nicht lichtempfindliche Säure bildende Verbindungen als Initiatoren der Solubilisierungsreaktion eingesetzt werden, z.B. halogenierte aromatische Verbindungen oder halogenierte polymere Kohlenwasserstoffe. Auch Röntgenstrahlen können zur Bilderzeugung verwendet werden.

Die bildmäßig belichtete oder bestrahlte Schicht kann in bekannter Weise mit praktisch den gleichen Entwicklern wie für handelsübliche Naphthochinondiazid-Schichten und Kopierlacke entfernt werden, oder die neuen Materialien können in ihrem Kopierverhalten mit Vorteil auf die bekannten Hilfsmittel wie Entwickler und programmierte Sprühentwicklungsgeräte abgestimmt werden. Die wäßrigen Entwicklerlösungen können z.B. Alkaliphosphate, -silikate oder -hydroxide und ferner Netzmittel sowie ggf. kleinere Anteile organischer Lösungsmittel enthalten. In bestimmten Fällen sind auch Lösungsmittel-Wasser-Gemische als Entwickler brauchbar. Die Wahl des günstigsten Entwicklers kann durch Versuche mit der jeweils verwendeten Schicht ermittelt werden. Bei Bedarf kann die Entwicklung mechanisch unterstützt werden.

Bei der Anwendung als Druckplatten können zur Erhöhung der Widerstandsfähigkeit beim Druck sowie der Resistenz gegen Auswaschmittel, Korrekturmittel und durch UV-Licht härtbare Druckfarben die entwickelten Platten kurze Zeit auf erhöhte Temperaturen erwärmt werden, wie es für Diazoschichten aus der GB—A—1 154 749 bekannt ist.

Erfindungsgemäß wird auch ein Verfahren zur Herstellung von Reliefbildern vorgeschlagen, bei dem man ein strahlungsempfindliches Aufzeichnungsmaterial aus einem Schichtträger und einer Aufzeichnungsschicht, die aus dem eingangs definierten strahlungsempfindlichen Gemisch besteht,

bildmäßig mit aktinischer Strahlung in solcher Dosis bestrahlt, daß die Löslichkeit der Schicht in einer wäßrig-alkalischen Entwicklerlösung zunimmt, und die bestrahlten Schichtteile mittels einer wäßrig-alkalischen Entwicklerlösung entfernt. Das Verfahren ist dadurch gekennzeichnet, daß die Aufzeichnungsschicht als Bindemittel ein Polymerisat mit Vinylphenoleinheiten enthält.

Durch die Erfindung sind Positivschichten mit ausgezeichneter Flexibilität zugänglich, die die Vorteile aufweisen, bei der Verarbeitung als trockener Film auf dem Substrat gut zu haften und auch in größerer Schichtdicke von etwa 20 bis 100 µm und darüber keinerlei Risse oder Brüche in der Schicht zu zeigen. Vor allem beim Schnieden ergeben sich keinerlei Absplitterungen.

Im folgenden werden Beispiele für die Durchführung des erfindungsgemäßen Verfahrens bzw. für die Herstellung und Anwendung des erfindungsgemäßen Gemisches angegeben.

In den Beispielen sind Prozent- und Mengenverhältnisse, wenn nichts anders angegeben ist, in Gewichtseinheiten zu verstehen.

### Beispiel 1

Zur Herstellung einer Offsetdruckform wird folgende Beschichtungslösung hergestellt:

4 Gew.-Teile eines Copolymeren aus p-Hydroxystyrol und Butylmethacrylat (OH-Zahl 260; RSV-Wert 0,35 dl/g in Dimethylformamid),

1,2 Gew.-Teile eines Polyacetals, hergestellt aus Triethylenglykol und Butyraldehyd,

0,05 Gew.-Teile 2-(4-Ethoxy-naphth-1-yl)-4,6-bis-trichlormethyl-s-triazin,

0,01 Gew.-Teile Kristallviolettbase,

94,7 Gew.-Teile Methylethylketon.

Mit dieser Beschichtungslösung werden Platten aus gebürstetem Aluminium beschichtet. Nach dem Trocknen werden Schichtdicken von 1,0—1,5 µm erhalten.

Die Platten werden 5 Sekunden unter einer 5-kW-Metallhalogenidlampe belichtet und nach einer Wartezeit von 10 Minuten mit der folgenden Lösung entwickelt:

5,3 Gew.-Teile Natriummetasilikat × 9 $H_2O$,

3,4 Gew.-Teile Trinatriumphosphat × 12 $H_2O$,

0,3 Gew.-Teile Natriumdihydrogenphosphat (wasserfrei),

91,0 Gew.-Teile Wasser.

Durch die Entwicklung werden die vom Licht getroffenen Anteile der Kopierschicht entfernt, und es bleiben die unbelichteten Bildstellen auf dem Schichtträger zurück. Die so hergestellte Druckform erlaubt eine hohe Druckauflage.

### Beispiel 2

Zur Herstellung eines Positiv-Trockenresists werden

40 Gew.-Teile eines Copolymeren aus 4-Hydroxy-3-methoxystyrol und Hexylmethacrylat (OH-Zahl 246; RSV-Wert 0,36 dl/g in Dimethylformamid),

11,7 Gew.-Teile eines Polyacetals, hergestellt aus Triethylenglykol und Butyraldehyd,

0,5 Gew.-Teile 2-(4-Ethoxy-naphth-1-yl)-4,6-bis-trichlormethyl-s-triazin und

0,1 Gew.-Teile Kristallviolettbase in

50 Gew.-Teilen Ethanol und

60 Gew.-Teilen Methylethylketon

gelöst. Diese Lösung wird auf eine 26 µm dicke, biaxial verstreckte und thermofixierte Polyethylenterephthalatfolie aufgeschleudert und anschließend 10 Minuten bei 100°C nachgetrocknet. Es resultiert eine Schichtdicke vom 25 µm. Zum Schutz gegen Staub und Verkratzungen wird darauf noch eine Polyethylendeckfolie kaschiert.

Dieser Trockenresistfilm weist eine hervorragende Flexibilität auf. Der Film auf der Trägerfolie läßt sich ohne weiteres falten, ohne daß Sprünge oder Risse in der Schicht auftreten.

Zur Herstellung von Leiterplatten wird dieser Trockenresistfilm nach Abziehen der Deckfolie in einem handelsüblichen Laminator auf einen gereinigten, vorgewärmten Träger, der aus einem Isolierstoffmaterial mit ein- oder beidseitiger, 35 µm dicker Kupferauflage besteht, laminiert. Nach Abziehen der Trägerfolie und Nachtrocknen wird unter einer Vorlage mit einer 5-kW-Metallhalogenidlampe (110 cm Abstand) ca. 50 Sekunden belichtet und — nach einer Wartezeit von 10 Minuten — 1 Minute in dem in Beispiel 1 angegebenen Entwickler entwickelt. Die entstandene Resistschablone weist eine hervorrangende Galvanoresistenz auf, insbesondere bei dem galvanischen Aufbau von Kupfer und Pb/Sn-Legierung.

Derartig behandelte Platten lassen sich anschließend erneut belichten und entwickeln. Nach dem Ätzen des freigelegten Kupfers erhält man eine Leiterplatte in Kupfertechnik.

### Beispiel 3

Beispiel 2 wird wiederholt, wobei anstelle des Copolymeren aus 4-Hydroxy-3-methoxystryol und Hexylmethacrylat ein Copolymer aus 4-Hydroxystyrol und 2-Ethyl-hexylmethacrylat mit der OH-Zahl 280 und einem RSV-Wert von 0,478 dl/g in Dimethylformamid verwendet wird.

Auch in diesem Fall erhält man einen positiv arbeitenden Trockenresist mit hervorragender Flexibilität und Haftung auf dem Kupfersubstrat.

Beispiel 4

Eine Beschichtungslösung aus

8,0 Gew.-Teilen eines Copolymeren aus 4-Isopropenylphenol und Methylmethacrylat (OH-Zahl 310; RSV-Wert 0,189 dl/g in Dimethylformamid),

0,8 Gew.-Teilen eines polymeren Orthoesters, hergestellt durch Kondensation von Orthoameisensäuretrimethylester mit 4-Oxa-6,6-bis hydroxymethyl-octan-1-ol,

0,03 Gew.-Teilen 2-(4-Styrylphenyl)-4,6-bis-trichlormethyl-s-triazin und

0,01 Gew.-Teilen Kristallviolettbase in

180 Gew.-Teilen Methylethylketon

wird auf einen mit Metalldrahtbürsten aufgerauhten Aluminiumträger aufgebracht und getrocknet. Die erhaltene lichtempfindliche Schicht hat ein Schichtgewicht von ca. 1,5 $g/m^2$. Die Druckplatte wird mit der in Beispiel 1 angegebenen Lichtquelle unter einer Vorlage 5 Sekunden belichtet. Nach 30 Sekunden Entwickeln mit einer Lösung aus

0,6% NaOH,

0,5% Natriummetasilikat × 5 $H_2O$ und

1,0% n-Butanol in

97,9% Wasser

erhält man eine saubere Kopie der Vorlage. Die unbestrahlten Bereiche lassen sich mit fetter Farbe — wie für Offsetdruckplatten üblich — einfärben.

Beispiel 5

Eine Photoresistlösung wird hergestellt aus

12,5 Gew.-Teilen eines Copolymeren aus 4-Hydroxy-styrol und Styrol (OH-Zahl 260; RSV-Wert 0,176 dl/g in Dimethylformamid),

2,1 Gew.-Teilen eines Polyacetals aus Triethylenglykol und 2-Ethylbutyraldehyd,

0,1 Gew.-Teilen 2-(4-Styryl-phenyl)-4,6-bis-trichlormethyl-s-triazin und

0,05 Gew.-Teilen Kristallviolettbase in

85 Gew.-Teilen 2-Ethoxy-ethylacetat.

Die Lösung wird anschließend durch ein Filter mit einem Porendurchmesser von 0,2 µm (Millipore) filtriert.

Der Resist wird auf einen Wafer mit einem $SiO_2$-Film aufgeschleudert, wobei eine Schichtdicke von 1,0 µm erhalten wird.

Anschließend wird eine Testbildmaske in innigen Kontakt mit dem Wafer gebracht, der 15 Sekunden mit UV-Licht einer Intensität von 4,5 $mW/cm^2$ bei 365 nm belichtet wird.

Nach 10 Minuten Wartezeit wird 40 Sekunden mit dem Entwickler aus Beispiel 1 entwickelt.

Das erhaltene Bildmuster zeigt eine Auflösung von 1,0 µm.

Beispiel 6

Eine Photoresistlösung wird hergestellt aus

55 Gew.-Teilen eines Copolymeren aus 4-Hydroxy-styrol und Hexylmethacrylat (OH-Zahl 290; RSV-Wert 0,55 dl/g in Dimethylformamid),

15 Gew.-Teilen des in Beispiel 5 angegebenen Polyacetals,

0,4 Gew.-Teilen 2-(4-Ethoxy-naphth-1-yl)-4,6-bis-trichlormethyl-s-triazin,

0,07 Gew.-Teilen Kristallviolettbase,

170 Gew.-Teilen Ethanol.

Mit dieser Lösung wird entsprechend Beispiel 2 ein Positiv-Trockenresistfilm von 25 µm Dicke hergestellt. Damit lassen sich in der oben beschreibenen Weise Leiterplatten in Kupfertechnik herstellen. Der Resist weist eine hervorragende Flexibilität und eine gute Haftung zum Kupfer auf.

Ein Trockenresist der genannten Zusammensetzung mit einem Novolak in gleicher Menge anstelle des Copolymeren zeigt beim Schneiden Flitterbildung und Brüche, weiterhin kommt es beim Laminieren des Resists häufig zum Umspringen des Films von der Träger- auf die Deckfolie.

Beispiel 7

Die Eignung der neuen Bindemittel in elektronenstrahlenempfindlichen Schichten wird im folgenden gezeigt:

Auf mechanisch aufgerauhtes Aluminium ca. 1 µm dick aufgetragene Schichten aus

70 Gew.-Teilen des Copolymeren nach Beispiel 6,

25 Gew.-Teilen des Bis-(5-butyl-5-ethyl-1,3-dioxan-2-yl)-ethers des 2-Butyl-2-ethylpropandiols und

5 Gew.-Teilen des in Beispiel 1 angegebenen Triazins

werden mit 11 kV-Elektronen bestrahlt.

Bei einem Strahlstrom von 5 µA reichen 4 Sekunden Bestrahlungsdauer aus, um ein Feld von 10 $cm^2$ nach 120 Sekunden Einwirkung des Entwicklers aus Beispiel 1 löslich zu machen; das entspricht einer Empfindlichkeit der oben genannten Schichten von $74 \cdot 10^3$ Zerfälle/$s \cdot cm^2$.

Beispiel 8

Eine Photoresistlösung wird hergestellt aus

10 Gew.-Teilen eines Copolymeren aus Isoeugenol und Maleinsäureanhydrid (RSV-Wert: 0,343 dl/g in Dimethylformamid),

1,9 Gew.-Teilen des in Beispiel 1 angegebenen Polyacetals,

0,1 Gew.-Teilen 2-(4-Styryl-phenyl)-4,6-bis-trichlormethyl-s-triazin und

40 Gew.-Teilen 1-Methoxy-2-propanol.

Die Lösung wird anschließend durch ein Filter mit einem Porendurchmesser von 0,2 µm filtriert. Nach Aufschleudern auf einen Wafer mit einem $SiO_2$-Film resultiert eine Schichtdicke von 1,2 µm.

Anschließend wird eine Testbildmaske in innigen Kontakt mit dem Wafer gebracht und 15 s mit UV-Licht einer Intensität von 4,5 $mW/cm^2$ bei 365 nm belichtet.

Nach 10 Minuten Wartezeit wird 30 s mit einem Entwickler aus Beispiel 1 (1:1 verdünnt mit $H_2O$) entwickelt.

Das erhaltene Bildmuster zeigt eine Auflösung von 1,5 µm.

Beispiel 9

Zur Herstellung dicker Resistschichten wird eine Lösung hergestellt aus

13,5 Gew.-Teilen eines Copolymeren aus 3-Hydroxystyrol und n-Hexylmethacrylat (OH-Zahl: 298, RSV-Wert 0,30 in Dimethylformamid),

5,8 Gew.-Teilen eines Kresol-Formaldehyd-Novolaks (Schmelzbereich 105—120°C nach DIN 53181),

5,3 Gew.-Teilen des in Beispiel 1 angegebenen Polyacetals,

0,15 Gew.-Teilen 2-(3-Methoxy-naphth-2-yl)-4,6-bis-trichlormethyl-s-triazin,

0,05 Gew.-Teilen Kristallviolettbase und

68,5 Gew.-Teilen Methylethylketon.

Damit wird eine biaxial verstreckte und thermofixierte 26 µm dicke folie aus Polyethylenterephthalat, die mit einer Lösung von Trichloressigsäure und Polyvinylalkohol vorbehandelt ist, so beschichtet und getrocknet, daß darauf eine 18 µm dicke gleichmäßige Resistschicht entsteht.

Zur Herstellung von Leiterplatten wird dieser Trockenresist in der in Beispiel 2 beschreibenen Weise auf einen vorgewärmten Träger laminiert und 50 Sekunden unter einer Vorlage mit einer 5 kW-Metallhalogenidlampe belichtet. Nach einer Wartezeit von 10 Minuten wird mit 1% iger NaOH entwickelt.

Das erhaltene Bildmuster weist eine hervorragende Haftung und Galvanoresistenz auf. Es lassen sich damit nach galvanischem Aufbau von Blei/Zinn und erneutem Differenzieren und Ätzen Leiterplatten in Kupfertechnik herstellen.

Beispiel 10

Mit einer Beschichtungslösung aus

20,0 Gew.-Teilen eines Copolymeren aus 4-Hydroxystyrol und n-Hexylmethacrylat (OH-Zahl: 309, RSV-Wert 0,289 dl/g in Dimethylformamid),

5,33 Gew.-Teilen des in Beispiel 1 angegebenen Polyacetals,

0,14 Gew.-Teilen des in Beispiel 9 angegebenen Triazins,

0,02 Gew.-Teilen Kristallviolettbase,

0,0025 Gew.-Teilen eines modifizierten Silikonglykols und

200 Gew.-Teilen Methylethylketon

werden Platten aus gebürstetem Aluminium beschichtet. Nach dem Trocknen werden Schichtdicken von 1,0—1,5 µm erhalten.

Die Schicht zeichnet sich durch einen ausgezeichneten Verlauf aus.

Nach Belichten mit der in Beispiel 1 angegebenen Lichtquelle unter einer Vorlage und Entwickeln mit dem in Beispiel 1 angegebenen Entwickler erhält man eine saubere Kopie die Vorlage. Die unbestrahlten Bereiche lassen sich mit fetter Farbe einfärben, und mit der so hergestellten Druckform konnten Drucke in hoher Auflage hergestellt werden.

Beispiel 11

Zur Herstellung eines Positiv-Trockenresists wird eine Lösung aus

10 Gew.-Teilen eines Copolymeren aus 4-Hydroxystyrol und Butylacrylat (OH-Zahl: 263, RSV-Wert: 0,402 dl/g in Dimethylformamid),

2,1 Gew.-Teilen des in Beispiel 1 angegebenen Polyacetals,

0,1 Gew.-Teilen in Beispiel 4 angegebenen Triazins und

0,015 Gew.-Teilen Kristallviolettbase in

30 Gew.-Teilen Methylethylketon

auf eine Polyethylenterephthalatfolie, wie sie in Beispiel 2 beschreiben ist, aufgeschleudert. Der resultierende Trockenresistfilm weist eine sehr gute Elastizität auf.

Analog Beispiel 2 lassen sich damit Leiterplatten in Kupfertechnik herstellen.

**Patentansprüche**

1. Strahlungsempfindliches Gemisch, das

a) ein in Wasser unlösliches, in wäßrig-alkalischen Lösungen lösliches polymeres Bildemittel,

b) eine unter Einwirkung von aktinischer Strahlung eine starke Säure bildende Verbindung und

c) eine Verbindung mit mindestens einer durch Säure spaltbaren C—O—C-Bindung enthält, deren Löslichkeit in einem flüssigen Entwickler durch Einwirkung von Säure erhöht wird,

dadurch gekennzeichnet, daß das Bindemittel ein Polymerisat ist, das Alkenylphenoleinheiten enthält.

2. Strahlungsempfindliches Gemisch nach Anspruch 1, dadurch gekennzeichnet, daß das Polymerisat Einheiten der allgemeinen Formel I

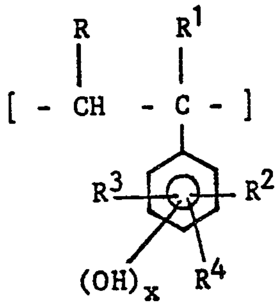

(I)

enthält, worin

R ein Wasserstoffatom, eine Cyanid-, Alkyl- oder Phenylgruppe,

$R^1$ ein Wasserstoff- oder Halogenatom, eine Cyanid- oder Alkylgruppe,

$R^2$, $R^3$ und $R^4$ Wasserstoff-, Halogenatome, Alkyl- oder Alkoxygruppen und

x eine Zahl von 1 bis 3

bedeuten.

3. Strahlungsempfindliches Gemisch nach Anspruch 2, dadurch gekennzeichnet, daß das Polymerisat ein Copolymerisat aus Einheiten der Formel I und Einheiten anderer Vinylverbindungen ist.

4. Strahlungsempfindliches Gemisch nach Anspruch 3, dadurch gekennzeichnet, daß die Einheiten der anderen Vinylverbindungen der allgemeinen Formel II

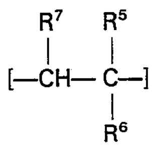

(II)

entsprechen, worin

$R^5$ ein Wasserstoff- oder Halogenatom oder eine Alkylgruppe

$R^6$ eine Alkyl-, Alkoxy-, Alkyloxycarbonyl-, Acyl-, Acyloxy-, Aryl-, Formyl-, Cyanid-, Carboxyl-, Hydroxy- oder Aminocarbonylgruppe und

$R^7$ ein Wasserstoffatom oder eine Carboxylgruppe ist, die mit $R^6$, wenn dieses eine Carboxylgruppe ist, zu einem Säureanhydrid verbunden sein kann.

5. Strahlungsempfindliches Gemisch nach Anspruch 2, dadurch gekennzeichnet, daß das Polymerisat Einheiten der allgemeinen Formel I enthält, x = 1 ist.

6. Strahlungsempfindliches Gemisch nach Anspruch 1, dadurch gekennzeichnet, daß die Verbindung (c) eine Verbindung mit mindestens einer Orthocarbonsäureester-, Carbonsäureamidacetal-, Acetal-, Enolether- oder Acyliminocarbonatgruppierung ist.

7. Strahlungsempfindliches Gemisch nach Anspruch 1, dadurch gekennzeichnet, daß es 30 bis 90 Gew.-% des polymeren Bindemittels (a), 0,1 bis 10 Gew.-% der Säure bildenden Verbindung (b) und 5 bis 70 Gew.-% der säurespaltbaren Verbindung (c) enthält.

8. Strahlungsempfindliches Aufzeichnungsmaterial mit einem Schichtträger und einer Aufzeichnungsschicht, dadurch gekennzeichnet, daß sie das strahlungsempfindliche Gemisch gemäß Anspruch 1 enthält.

9. Strahlungsempfindliches Aufzeichnungsmaterial nach Anspruch 8, dadurch gekennzeichnet, daß der Schichtträger eine flexible, transparente Kunststoffolie ist und daß die andere Oberfläche der Aufzeichnungsschicht mit einer Deckfolie abgedeckt ist, deren Haftung an der Aufzeichnungsschicht geringer ist als die des Schichtträgers.

10. Verfahren zur Herstellung von Reliefbildern, bei dem man ein strahlungsempfindliches Aufzeichnungsmaterial gemäß Anspruch 8 bildmäßig mit aktinischer Strahlung in solcher Dosis bestrahlt, daß die Löslichkeit in einer wäßrigalkalischen Entwicklerlösung zunimmt, und die bestrahlten Schichtteile

mittels einer wäßrig-alkalischen Lösung entfernt.

11. Verfahren nach Anspruch 10, dadurch gekennzeichnet, daß man das Aufzeichnungsmaterial gemäß Anspruch 8 und 9 einsetzt, daß man die Deckfolie von der Aufzeichnungsschicht abzieht, das verbleibende Aufzeichnungsmaterial mit der freigelegten Seite der Aufzeichnungsschicht unter Druck und Erwärmen auf einen endgültigen Schichtträger laminiert, die Aufzeichnungsschicht bildmäßig belichtet und nach dem Abziehen des transparenten Schichtträgers die Aufzeichnungsschicht entwickelt.

**Revendications**

1. Composition sensible aux radiations, contenant en tant que composants essentiels

a) un liant polymère insoluble dans l'eau, soluble dans des solutions aqueuses alcalines,

b) un composé formant un acide fort sous l'effet d'un rayonnement actinique, et

c) un composé comportant au moins une liaison C—O—C pouvant être rompue par un acide, dont la solubilité dans un révélateur liquide est accrue sous l'effet d'un acide,

caractérisé en ce que le liant est un polymère qui contient des motifs alcénylphénol.

2. Composition sensible aux radiations selon la revendication 1, caractérisée en ce que le polymère contient des motifs de formule générale I

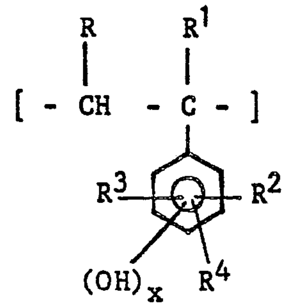

(I)

dans laquelle

R est un atome d'hydrogène ou un groupe cyano, alkyle ou phényle,

$R^1$ représente un atome d'hydrogène ou d'halogène, un groupe cyano ou alkyle,

$R^2$, $R^3$ et $R^4$ représentent des atomes d'hydrogène ou d'halogène, ou des groupes alkykle ou alcoxy, et

x est un nombre allant de 1 à 3.

3. Composition sensible aux radiations selon la revendication 2, caractérisée en ce que le polymère est un copolymère à base de motifs de formule I et de motifs d'autres composés vinyliques.

4. Composition sensible aux radiations selon la revendication 3, caractérisée en ce que les motifs des autres composés vinyliques correspondent à la formule générale II

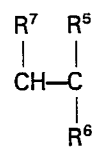

dans laquelle

$R^5$ est un atome d'hydrogène ou d'halogène ou un groupe alkyle,

$R^6$ est un groupe alkyle, alcoxy, alkyloxycarbonyle, acyle, acyloxy, aryle, formyle, cyano, carboxy, hydroxy ou aminocarbonyle, et

$R^7$ est un atome d'hydrogène ou un groupe carboxy qui peut être lié à $R^6$, lorsque celui-ci est un groupe carboxy, pour donner un anhydride d'acide.

5. Composition sensible aux radiations selon la revendication 2, caractérisée en ce que le polymère contient des motifs de formule générale I dans lesquels x = 1.

6. Composition sensible aux radiations selon la revendication 1, caractérisée en ce que le composé (c) est un composé comportant au moins un groupement ester d'acide orthocarboxylique, acétal de carboxamide, acétal, énol-éther ou acyliminocarbonate.

7. Composition sensible aux radiations selon la revendication 1, caractérisée en ce qu'elle contient de 30 à 90% en poids du liant polymère (a), de 0,1 à 10% en poids du composé (b) générateur d'acide, et de 5 à 70% en poids du composé (c) dissociable par un acide.

8. Matériau de reprographie sensible aux radiations, comportant un support de couche et une couche de reprographie, caractérisé en ce qu'il contient la composition sensible aux radiations selon la revendication 1.

9. Matériau de reprographie sensible aux radiations selon la revendication 8, caractérisé en ce que le support de couche est une feuille de matière plastique flexible transparente et en ce que l'autre surface de la couche de reprographie est recouverte par une feuille de recouvrement dont l'adhérence à la couche de

reprographie est plus faible que celle du support de couche.

10. Procédé pour la production d'images en relief, dans lequel on irradie selon l'image un matériau de reprographie sensible aux radiations selon la revendication 8, avec un rayonnement actinique à une dose telle que la solubilité dans une solution aqueuse alcaline de développement augmente, et on élimine à l'aide d'une solution aqueuse alcaline les zones irradiées de la couche.

11. Procédé selon la revendication 10, caractérisé en ce que l'on utilise le matériau de reprographie selon les revendications 8 et 9, en ce que l'on sépare la feuille de recouvrement de la couche de reprographie, on applique par pelliculage le matériau de reprographie restant, avec la face mise à nu de la couche de reprographie, sous pression et avec chauffage, sur un support de couche final, on expose selon l'image la couche de reprographie et après enlèvement du support de couche transparent, on développe la couche de reprographie.

**Claims**

1. Radiation-sensitive composition containing

a) a polymeric binder which is insoluble in water and soluble in aqueous-alkaline solutions,

b) a compound which forms a strong acid under the action of actinic radiation, and

c) a compound which has at least one acid-cleavable C—O—C bond and the solubility of which in a liquid developer is increased by the action of acid,

wherein the binder is a polymer containing alkenyl phenol units.

2. A radiation-sensitive composition as claimed in claim 1, wherein the polymer contains units of the general formula I

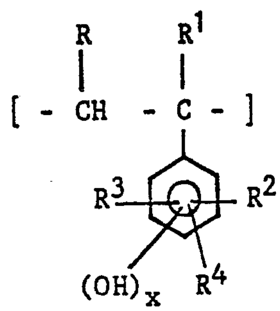

(I)

wherein

R denotes a hydrogen atom, a cyanide group, or an alkyl group or a phenyl group,

$R^1$ denotes a hydrogen atom or a halogen atom, a cyanide group or an alkyl group,

$R^2$, $R^3$ and $R^4$ denote hydrogen atoms, halogen atoms, alkyl groups or alkoxy groups, and

x stands for a number from 1 to 3.

3. A radiation-sensitive composition as claimed in claim 2, wherein the polymer is a copolymer comprising units of the formula I and units of other vinyl compounds.

4. A radiation-sensitive composition as claimed in claim 3, wherein the units of the other vinyl compounds correspond to the general formula II

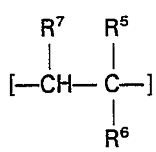

(II)

wherein

$R^5$ is a hydrogen atom or a halogen atom, or an alkyl group,

$R^6$ is an alkyl group, alkoxy group, alkyloxycarbonyl group, acyl group, acyloxy group, aryl group, formyl group, cyanide group, carboxyl group, hydroxyl group or aminocarbonyl group, and

$R^7$ is a hydrogen atom or a carboxyl group which may be linked with $R^6$ to form an acid anhydride, if $R^6$ is a carboxyl group.

5. A radiation-sensitive composition as claimed in claim 2, wherein the polymer contains units of the general formula I, in which x = 1.

6. A radiation-sensitive composition as claimed in claim 1, wherein the compound (c) is a compound comprising at least one orthocarboxylic acid ester, carboxylic acid amide acetal, acetal, enolether, or acyliminocarbonate grouping.

7. A radiation-sensitive composition as claimed in claim 1, which contains from 30 to 90% by weight of the polymeric binder (a), from 0.1 to 10% by weight of the acid-forming compound (b), and from 5 to 70% by weight of the acid-cleavable compound (c).

8. Radiation-sensitive recording material composed of a support and a recording layer which contains

the radiation-sensitive composition as claimed in claim 1.

9. A radiation-sensitive recording material as claimed in claim 8, wherein the support comprises a flexible, transparent plastics film and wherein the other surface of the recording layer is covered by a covering film, which has a lower adhesion to the recording layer than the support.

10. Process for the production of relief images, in which a radiation-sensitive recording material as claimed in claim 8 is irradiated imagewise with actinic radiation in a dose such that the solubility in an aqueous-alkaline developer solution is increased and the irrdiated portions of the layer are removed by means of an aqueous-alkaline solution.

11. A process as claimed in claim 10, wherein the recording material as claimed in claims 8 and 9 is employed and wherein the covering film is peeled from the recording layer, the remaining recording material is laminated with the bared surface of the recording layer to a final support, by applying pressure and heating, the recording layer is exposed imagewise and, after peeling off the transparent support, the recording layer is developed.